# EUROPEAN PATENT SPECIFICATION

(11) **EP 0 512 711 B1**
(45) Date of publication and mention of the grant of the patent: **07.07.1999**
(21) Application number: 92303578.6
(22) Date of filing: 22.04.1992
(51) Int. Cl.: G01R 31/36, H04M 1/72

(54) **Device for measuring the quantity of electricity stored in a battery**
Einrichtung zur Messung der in einer Batterie gespeicherten Elektrizitätsmenge
Dispositif de mesure de la quantité d'électricité stockée dans une batterie

(30) Priority: 07.05.1991 JP 10129991
(43) Date of publication of application: 11.11.1992
(73) Proprietor: MATSUSHITA ELECTRIC INDUSTRIAL CO., LTD., Kadoma-shi, Osaka-fu, 571 (JP)
(72) Inventor: Higuchi, Sadamu, Yokohama-shi (JP)
(74) Representative: Smith, Norman Ian

(56) References cited:
- EP-A- 0 473 187
- GB-A- 2 090 666
- US-A- 4 356 481
- PATENT ABSTRACTS OF JAPAN vol. 14, no. 408 (E-972)4 September 1990 & JP-A-2 152 351 ( MATSUSHITA ) 12 June 1990
- PATENT ABSTRACTS OF JAPAN vol. 15, no. 148 (E-1056)15 April 1991 & JP-A-3 023 726 ( MATSUSHITA ) 31 January 1991

## Description

### BACKGROUND OF THE INVENTION

This invention relates to a device which is equipped in such a radio communication apparatus as a time-division-multiplex mobile transceiver, portable telephone unit or indoor wireless telephone unit and is intended to measure the quantity of electricity stored in the battery used in the apparatus thereby to indicate the quantity of consumed electricity after the battery has been charged.

Fig. 4 shows the arrangement of a conventional device for measuring the quantity of battery electricity. In the figure, indicated by 2 is a voltage detection circuit which detects the voltage of a battery 1 and delivers the voltage level to an A/D converter 3. Output data of the A/D converter 3 is fed to a digital display panel 4, and it calculates the quantity of electricity of the battery 1 based on the characteristics of the battery, i.e., the relation between the quantity of electricity and the output voltage, and displays the result. The A/D converter 3 is capable of displaying the quantity of battery electricity consumed by a time-division-multiplex transceiver 5.

However, the conventional battery electricity measuring device shown in Fig. 4 needs to measure a pulsative battery voltage resulting from pulsative power consumption by the time-division-multiplex transceiver 5, and therefore it is deficient in the accuracy of measurement.

Particularly, a digital automobile telephone unit has its transmission power output varied in response to the radio signal from the base station, and such a varying pulsative battery voltage makes the electricity measurement more difficult.

### SUMMARY OF THE INVENTION

An object of this invention is to provide a device capable of accurately measuring the quantity of battery electricity through the synchronization of operation of the A/D converter with the time-division-multiplex control signal provided by the time-division-multiplex transceiver.

In order to achieve the above objective, the electricity measuring device based on this invention is designed to calculate the quantity of battery electricity by detecting the battery voltage during the inactive period of transmission and reception of the unit. In consequence, a stable battery voltage is detected, and the quantity of battery electricity can be measured accurately.

GB-2,090,666-A discloses a method of determining the state of discharge of an electric battery in which the battery potential of a battery powered watch is measured at a regular frequency sampling rate and the blocking signals are introduced to block out the measurements being taken except during certain periods. This is necessary when a system like a watch has to be monitored because a number of different current levels arise at different times. This introduces a degree of complexity to the operation.

Patent Abstracts of Japan Vol 14 no. 408 discloses a cordless telephone circuit in which a remaining capacity detecting circuit of a mobile station detects the terminal voltage of a storage battery. However the system requires the operation to be repeated continuously.

The present invention aims to overcome the problems of the prior art and accordingly is characterised in that activation means adapted to activate said electricity calculation means to calculate on the basis of the supply voltage of said battery detected at a time point when neither transmission nor reception is taking place by said transceiver section by being so connected to said control section as to receive therefrom a timing signal based on the time division multiplex access control at the mobile radio communication apparatus.

### BRIEF DESCRIPTION OF THE DRAWINGS

Fig. 1 is a block diagram showing the arrangement of the battery electricity measuring device based on a first embodiment embodiment of this invention;
Figs 2A-2C are waveform diagrams used to explain the operation of the device shown in Fig. 1;
Fig. 3 is a block diagram showing the arrangement of the battery electricity measuring device based on a second embodiment embodiment of this invention; and
Fig. 4 is a block diagram showing the arrangement of the conventional battery electricity measuring device.

### DESCRIPTION OF THE PREFERRED EMBODIMENTS

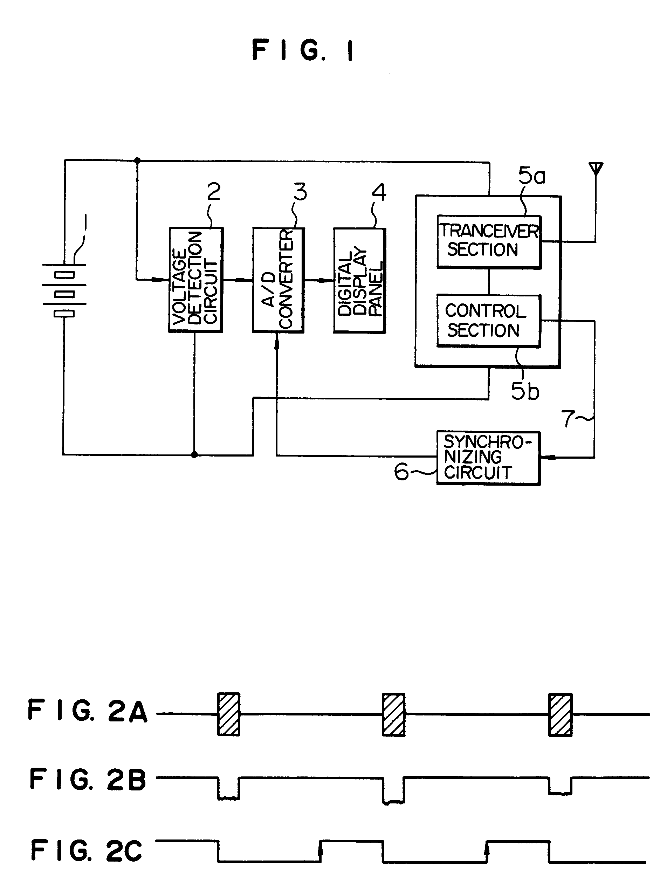

Fig. 1 shows the battery electricity measuring device based on this invention. In the figure, indicated by 1 is a battery, 2 is a voltage detection circuit for detecting the output voltage of the battery 1, 3 is an A/D converter, 4 is a digital display panel, 5 is a time-division-multiplex transceiver which operates on the battery 1, and 6 is a synchronizing circuit. The transceiver 5 consists of a transceiver section 5a and a control section 5b which controls the transceiver section 5a. The transceiver 5 produces a timing signal 7 for the time-division-multiplex transmission control, and the signal is fed to the synchronizing circuit 6 so that the output of the circuit 6 controls the timing of sampling of the battery voltage by the A/D converter 3.

The operation will be explained in more detail with reference to Figs. 2A-2C. The time-division-multiplex transceiver has intermittent transmission outputs as shown by Fig. 2A. This load variation causes the battery output voltage to pulsate as shown by Fig. 2B. The transmitting operation takes place in response to the command from the time-division-multiplex controller 5b in the transceiver 5, and the A/D converter 3 is designed to sample the battery voltage when transmission output is off by being timed to the timing signal 7 provided by the time-division-multiplex controller. For this implementation, the timing signal 7 is applied to the synchronizing circuit 6 so that the A/D converter 3 operates at the rising edge of the output pulse signal as shown by Fig. 2C. Consequently, according to this invention, the A/D converter 3 detects the battery voltage during the period when it is stable because of little power consumption of the battery 1, and the detection result is accurate enough to calculate the quantity of electricity of the battery 1.

Many time-division-multiplex transceivers base their time-division-multiplex control on the microcomputer incorporated in the transceiver 5, and the timing signal 7 used for this control is produced by means of programming.

The digital display panel 4, which functions to calculate the quantity of electricity of the battery 1 from the battery voltage, is mainly controlled by the microcomputer. It is also possible for this invention to use a single microcomputer and associated program for synchronizing the detection of battery voltage with the time-division-multiplex control.

Resulting data based on the accurate detection is used by the digital display panel 4 for displaying the residual electricity of the battery at a resolution of five levels for example, or indicating the alarm of too-low battery voltage.

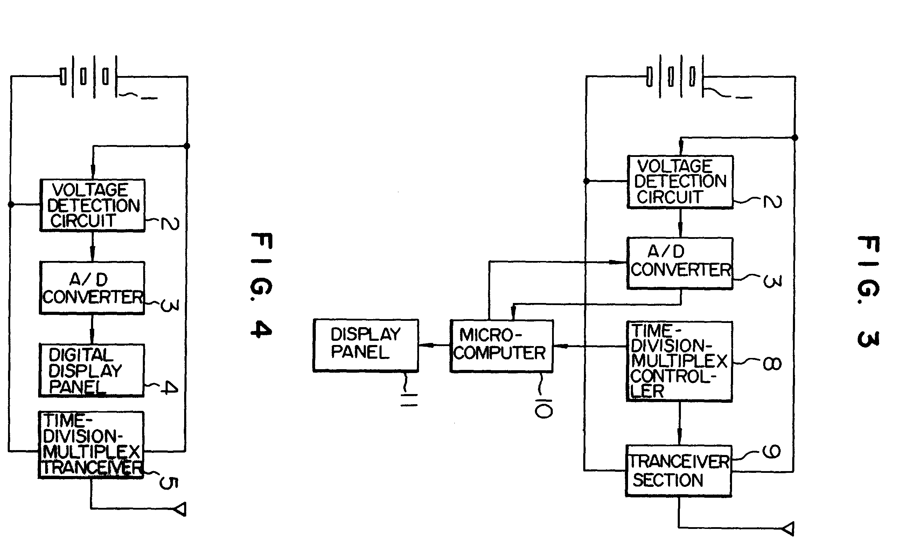

Fig. 3 shows another embodiment of this invention. In this embodiment, the time-division-multiplex transceiver 5 shown in Fig. 1 is divided into a time-division-multiplex controller 8 and a transceiver section 9, and the synchronizing circuit 6 and digital display panel 4 in Fig. 1 are replaced with a microcomputer 10 and a display panel 11.

The arrangement of Fig. 3 operates such that the time-division-multiplex controller 8 controls the operational timing of the transceiver section 9 and imparts the timing of transmission to the microcomputer 10. The microcomputer 10 imparts the timing of operation to the A/D converter 3, which then returns the voltage data to the microcomputer 10, and it calculates the quantity of battery electricity from the data. The result of calculation of the microcomputer 10 is displayed on the display panel 11.

It is possible for the time-division-multiplex controller 8 and microcomputer 10 to be replaced with a single control microcomputer.

The present invention is also applicable to mobile transceivers of the press-and-talk design, besides the foregoing time-division-multiplex mobile transceivers.

As will be appropriated from the above explanation of the embodiments, the time-division-multiplex transceiver is provided with the function of measuring the quantity of battery electricity in synchronism with the time-division-multiplex control of the unit, and consequently the quantity of residual electricity of the built-in battery can be measured and displayed accurately.

## Claims

1. A battery electricity measuring device adapted to measure a quantity of electricity stored in a battery (1) in combination with a mobile radio communication apparatus of a kind arranged to operate using a time division multiplex access control, said mobile radio communication apparatus including a transceiver section (5a) for transmitting and receiving a radio signal and a control section (5b) for controlling operation of said transceiver section (5a) in a time division multiplex manner, and said battery electricity measuring device comprising:
a voltage detection circuit (2) adapted to detect a supply voltage of said battery (1); and
electricity calculation means (4) adapted to calculate the quantity of electricity stored in said battery (1) on the basis of the supply voltage of said battery (1) detected by said voltage detection circuit (2);
characterised by:
activation means (6) adapted to activate said electricity calculation means (4) to calculate on the basis of the supply voltage of said battery (1) detected at a time point when neither transmission nor reception is taking place by said transceiver section (5a) by being so connected to said control section (5b) as to receive therefrom a timing signal (7) based on the time division multiplex access control at the mobile radio communication apparatus.

2. A battery electricity measuring device combination according to Claim 1, wherein said electricity calculation means (4) includes an analog-to-digital (A/D) converter (3).

3. A battery electricity measuring device combination according to Claim 1 or Claim 2, wherein said electricity calculation means (4) includes display means (11) for displaying a digital value calculated by said electricity calculation means (4).

4. A battery electricity measuring device combination according to Claim 1, wherein:
said activation means (6) is arranged to produce a sync signal which is synchronous with said timing signal; and
said electricity calculation means (4) is activated in accordance with said sync signal to provide a measurement at a time between intermittent transmission output pulses (Figure 2A).

5. A battery electricity measuring device combination according to Claim 3, wherein said control section (5b) is arranged to further function as said activation means (6) and means for driving said display means (11).

6. A battery electricity measuring device combination according to Claim 3 or 5, wherein said display means (11) is arranged to further function as means for alarming an abnormally low voltage of said battery.

7. A battery electricity measuring device combination according to any one of Claims 1 to 6, wherein said control section (5b) includes a microcomputer (10).

8. A battery electricity measuring device combination according to Claim 4, wherein said timing signal is arranged to be fed to said voltage detection circuit (2) in the case where said voltage detection circuit (2) has a sample and hold circuit or a truck and hold circuit for detecting the time point more precisely.

9. A battery electricity measuring method adapted to measure a quantity of electricity stored in a battery (1) which is used in a mobile radio communication apparatus of a time division multiplex access system, said mobile radio communication apparatus including a transceiver section (5a) for transmitting and receiving a radio signal and a control section (5b) for controlling operation of said transceiver section (5a) in a time division multiplex manner, said battery electricity measuring method comprising the steps of:
detecting a supply voltage of said battery (1) by means of a voltage detection circuit (2); and
calculating the quantity of electricity stored in said battery (1) on the basis of the supply voltage of said battery (1) detected by said voltage detection circuit (2);
characterised in that:
said detecting step and said calculating step are performed at a time point when neither transmission nor reception is taking place by said transceiver section (5a) on the basis of a timing signal (7) provided by said control section (5b).

10. A battery electricity measuring method according to Claim 9, further comprising the step of displaying a result of said calculating step on a display means (11).

## Patentansprüche

1. Batterieelektrizitäts-Meßvorrichtung, welche geeignet ist, die Menge von in einer Batterie (1) gespeicherten Elektrizität zu messen, in Kombination mit einem mobilen Funkkommunikationsgerät von der Art, das unter Verwendung einer Zeitmultiplex-Zugriffsteuerung arbeitet, wobei das mobile Funkkommunikationsgerät ein Transceiver-Glied (5a), das ein Radiosignal sendet und empfängt, und ein Steuerglied (5b) beinhaltet, das den Betrieb des Transceiver-Glieds (5a) in der Art eines Zeitmultiplex steuert, und die Batterieelektrizitäts-Meßvorrichtung aufweist:
eine Spannungserfassungsschaltung (2), welche zum Erfassen einer Speisespannung der Batterie (1) geeignet ist; und
eine Elektrizitäts-Berechnungseinrichtung (4), welche geeignet ist, die in der Batterie (1) gespeicherte Elektrizitätsmenge zu berechnen, und zwar basierend auf der Speisespannung der Batterie (1), welche von der Spannungserfassungsschaltung (2) erfaßt wurde;
gekennzeichnet durch:
eine Aktivierungseinrichtung (6), welche geeignet ist, die Elektrizitäts-Berechnungseinrichtung (4) dazu zu aktivieren, daß diese basierend auf der Speisespannung der Batterie (1), welche zu einem Zeitpunkt erfaßt wird, bei dem weder Senden noch Empfangen stattfindet, Berechnungen vornimmt, und zwar indem sie so mit dem Steuerglied (5b) verbunden ist, daß sie von diesem ein Taktsignal (7) basierend auf der Zeitmultiplex-Zugriffsteuerung des mobilen Funkkommunikationsgeräts empfängt.

2. Batterieelektrizitäts-Meßvorrichtungskombination nach Anspruch 1, bei dem die Elektrizitäts-Berechnungseinrichtung (4) einen Analog-Digital-(A/D)-Wandler (3) beinhaltet.

3. Batterieelektrizitäts-Meßvorrichtungskombination nach Anspruch 1 oder Anspruch 2, bei welcher die Elektrizitäts-Berechnungseinrichtung (4) eine Anzeigeeinrichtung (11) beinhaltet, die einen von der Elektrizitäts-Berechnungseinrichtung (4) berechneten digitalen Wert anzeigt.

4. Batterieelektrizitäts-Meßvorrichtungskombination nach Anspruch 1, bei welcher:
die Aktivierungseinrichtung (6) angeordnet ist, um ein Synchronisiersignal zu erzeugen, das synchron zu dem Taktsignal ist; und
die Elektrizitäts-Berechnungseinrichtung (4) in Übereinstimmung mit dem Synchronisiersignal aktiviert wird, um eine Messung zu einem Zeitpunkt zwischen intermittierenden Sendeausgangsimpulsen (Fig. 2A) zu liefern.

5. Batterieelektrizitäts-Meßvorrichtungskombination nach Anspruch 3, bei welcher das Steuerglied (5b) angeordnet ist, um weiter als Aktivierungseinrichtung (6) und Einrichtung zum Ansteuern der Anzeigeeinrichtung (11) zu fungieren.

6. Batterieelektrizitäts-Meßvorrichtungskombination nach Anspruch 3 oder 5, bei welcher die Anzeigeeinrichtung (11) angeordnet ist, um weiter als Einrichtung zum Warnen bei abnorm niedriger Spannung der Batterie zu fungieren.

7. Batterieelektrizitäts-Meßvorrichtungskombination nach einem der Ansprüche 1 bis 6, bei welcher das Steuerglied (5b) einen Mikrocomputer (10) beinhaltet.

8. Batterieelektrizitäts-Meßvorrichtungskombination nach Anspruch 4, bei welcher das Taktsignal angeordnet ist, um der Spannungserfassungsschaltung (2) zugeführt zu werden, falls die Spannungserfassungsschaltung (2) eine Abtast-Halte (Sample and Hold)-Schaltung oder eine 'Track-and-Hold' -Schaltung zum genaueren Erfassen des Zeitpunktes besitzt.

9. Batterieelektrizitäts-Meßverfahren, welches geeignet ist, die Elektrizitätsmenge zu messen, die in einer Batterie (1) gespeichert ist, welche in einem mobilen Funkkommunikationsgerät vom Zeitmultiplex-Zugriffssystems verwendet wird, wobei das mobile Funkkommunikationsgerät ein Transceiver-Glied (5a), das ein Funksignal sendet und empfängt, und ein Steuerglied (5b) beinhaltet, das den Betrieb des Transceiver-Glieds (5a) in der Art eines Zeitmultiplex steuert, wobei das Batterieelektrizitäts-Meßverfahren folgende Schritte umfaßt:
Erfassen einer Speisespannung der Batterie (1) mittels eines Spannungserfassungsschaltung (2); und
Berechnen der in der Batterie (1) gespeicherten Elektrizitätsmenge, und zwar basierend auf der von der Spannungserfassungsschaltung (2) erfaßten Speisespannung der Batterie (1);
dadurch gekennzeichnet, daß
der Erfassungsschritt und der Berechnungsschritt zu einem Zeitpunkt durchgeführt werden, bei dem das Transceiver-Glied (5a) weder Senden noch Empfangen durchführt, und zwar basierend auf einem vom Steuerglied (5b) gelieferten Taktsignal (7).

10. Batterieelektrizitäts-Meßverfahren nach Anspruch 9, welches weiter den Schritt des Anzeigens eines Ergebnisses des Berechnungsschrittes auf einer Anzeigeeinrichtung (11) umfaßt.

## Revendications

1. Dispositif de mesure de l'électricité d'une batterie conçu pour mesurer une quantité d'électricité stockée dans une batterie (1), combiné avec un appareil mobile de communication radio d'un type aménagé pour fonctionner en utilisant une commande d'accès multiplexe par répartition dans le temps, ledit appareil mobile de communication radio comprenant une section d'émetteur-récepteur (5a) destinée à transmettre et à recevoir un signal radio et une section de commande (5b) destinée à commander le fonctionnement de ladite section d'émetteur-récepteur (5a) d'une manière multiplexe par répartition dans le temps, et ledit dispositif de mesure de l'électricité d'une batterie comprenant :
un circuit de détection de tension (2) conçu pour détecter une tension de réseau de ladite batterie (1) ; et
un moyen de calcul de l'électricité (4) conçu pour calculer la quantité d'électricité stockée dans ladite batterie (1) sur la base de la tension de réseau de ladite batterie (1) détectée par ledit circuit de détection de tension (2) ;
caractérisé par :
un moyen d'activation (6) conçu pour activer ledit moyen de calcul de l'électricité (4) afin de calculer sur la base de la tension de réseau de ladite batterie (1) détectée à un moment où ni la transmission ni la réception ne sont mises en place par ladite section d'émetteur-récepteur (5a) en étant connecté de telle façon à ladite section de commande (5b) qu'il reçoit de celle-ci un signal de synchronisation (7) fondé sur la commande d'accès multiplexe par répartition dans le temps au niveau de l'appareil mobile de communication radio.

2. Combinaison de dispositif de mesure de l'électricité d'une batterie selon la revendication 1, dans laquelle ledit moyen de calcul de l'électricité (4) comprend un convertisseur analogique numérique (A/D) (3).

3. Combinaison de dispositif de mesure de l'électricité d'une batterie selon la revendication 1 ou la revendication 2, dans laquelle ledit moyen de calcul de l'électricité (4) comprend un moyen d'affichage (11) destiné à afficher une valeur numérique calculée par ledit moyen de calcul de l'électricité (4).

4. Combinaison de dispositif de mesure de l'électricité d'une batterie selon la revendication 1, dans laquelle :
ledit moyen d'activation (6) est aménagé pour produire un signal sync, lequel est synchronisé avec ledit signal de synchronisation ; et
ledit moyen de calcul de l'électricité (4) est activé conformément audit signal sync pour réaliser une mesure à un moment entre des impulsions intermittentes de sortie de transmission (Figure. 2A).

5. Combinaison de dispositif de mesure de l'électricité d'une batterie selon la revendication 3, dans laquelle ladite section de commande (5b) est aménagée pour fonctionner en outre en tant que dit moyen d'activation (6) et en tant que moyen pour commander ledit moyen d'affichage (11).

6. Combinaison de dispositif de mesure de l'électricité d'une batterie selon la revendication 3 ou 5, dans laquelle ledit moyen d'affichage (11) est aménagé pour fonctionner en outre en tant que moyen d'alarme d'une tension anormalement basse de ladite batterie.

7. Combinaison de dispositif de mesure de l'électricité d'une batterie selon l'une quelconque des revendications 1 à 6, dans laquelle ladite section de commande (5b) comprend un micro-ordinateur (10).

8. Combinaison de dispositif de mesure de l'électricité d'une batterie selon la revendication 4, dans laquelle ledit signal de synchronisation est agencé pour être amené audit circuit de détection de tension (2) dans le cas où ledit circuit de détection de tension (2) possède un échantillon et un circuit de signaux d'échantillonnage et de maintien ou un circuit de maintien débrochable pour détecter plus précisément le moment.

9. Procédé de mesure de l'électricité d'une batterie conçu pour mesurer une quantité d'électricité stockée dans une batterie (1), qui est utilisé dans un appareil mobile de communication radio faisant partie d'un système d'accès multiplex par répartition dans le temps, ledit appareil mobile de communication radio comprenant une section d'émetteur-récepteur (5a) destinée à transmettre et à recevoir un signal radio et une section de commande (5b) destinée à commander le fonctionnement de ladite section d'émetteur-récepteur (5a) d'une manière multiplexe par répartition dans le temps, ledit procédé de mesure de l'électricité d'une batterie comprenant les étapes de :
détection d'une tension de réseau de ladite batterie (1) au moyen d'un circuit de détection de tension (2) ; et
calcul de la quantité d'électricité stockée dans ladite batterie (1) sur la base de la tension de réseau de ladite batterie (1) détectée par ledit circuit de détection de tension (2) ;
caractérisé en ce que :
ladite étape de détection et ladite étape de calcul sont accomplies à un moment où ni la transmission ni la réception ne sont mises en place par ladite section d'émetteur-récepteur (5a) sur la base d'un signal de synchronisation (7) fourni par ladite section de commande (5b).

10. Procédé de mesure de l'électricité d'une batterie selon la revendication 9, comprenant en outre l'étape d'affichage sur un moyen d'affichage (11) d'un résultat de ladite étape de calcul.
